# EUROPÄISCHE PATENTSCHRIFT

(11) **EP 3 948 314 B1**
(45) Veröffentlichungstag und Bekanntmachung des Hinweises auf die Patenterteilung: **24.12.2025**
(21) Anmeldenummer: 19716813.1
(22) Anmeldetag: 28.03.2019
(51) Int. Cl.: G01R 31/58, G01R 31/12

(54) **VERFAHREN ZUM INSTANDHALTEN EINER ELEKTRISCHEN KOMPONENTE**
METHOD FOR MAINTAINING AN ELECTRICAL COMPONENT
PROCÉDÉ POUR ASSURER L'ENTRETIEN D'UN COMPOSANT ÉLECTRIQUE

(43) Veröffentlichungstag der Anmeldung: 09.02.2022
(73) Patentinhaber: Siemens Energy Global GmbH & Co. KG, 81739 München (DE)
(72) Erfinder: ARMSCHAT, Christoph, 91058 Erlangen (DE); DISTLER, Markus, 90419 Nürnberg (DE); HAFERMAAS, Jörg, 91056 Erlangen (DE); SÖLLNER, Nicolas, 91058 Erlangen (DE); SÖRGEL, Anna, 90489 Nürnberg (DE); WEIGT, Uwe, 91056 Erlangen (DE)
(86) Internationale Anmeldenummer: PCT/EP2019/057817
(87) Internationale Veröffentlichungsnummer: WO 2020/192919

(56) Entgegenhaltungen:
- CN-A- 108 761 293
- JP-A- 2000 091 058
- US-A1- 2012 239 321
- US-A1- 2014 176 336
- US-A1- 2018 017 610

## Beschreibung

Die Erfindung betrifft ein Verfahren zum Instandhalten einer elektrischen Komponente mit einem äußeren Isolator.

Eine solche elektrische Komponente kann beispielsweise ein Überspannungsableiter sein. Der Überspannungsableiter umfasst üblicherweise ein Widerstandselement, das zwischen einer elektrischen Leitung auf einem Betriebspotenzial von mehr als 1 kV und dem Erdpotenzial geschaltet ist. Der äußere Isolator umschließt das Widerstandselement und dient dazu, diesen von dessen Umgebung elektrisch zu isolieren.

Ein anderes Beispiel für eine artgemäße Komponente ist ein Stützisolator zur Stützung einer elektrischen Einrichtung, wie beispielsweise einer Schaltanlage oder eines Hochspannungsleiters.

Der äußere Isolator kann zweckmäßigerweise Isolatorschirme z.B. aus Porzellan oder Silikon umfassen.

Komponentenausfälle aufgrund von Fremdschichtüberschlägen treten bei Umspannanlagen, Hochspannungsgleichstromübertragungsanlagen, Blindleistungskompensationsanlagen oder dergleichen zwar nur relativ selten auf, ein einzelner Vorfall kann jedoch bereits zum Anlagenausfall führen.

Im Rahmen der Instandhaltung werden elektrische Komponenten der eingangs genannten Art üblicherweise per Sichtprüfung in einem bestimmten Rhythmus geprüft und nach Bedarf beispielsweise gereinigt. Zwischen den Wartungsvorgängen ist der Zustand der Komponentenverschmutzungen weitgehend unbekannt. Insbesondere für Verbundisolatoren ist die Sichtprüfung sehr ungenau, weil Isolatoren dieser Art schwankende hydrophobe Eigenschaften aufweisen können. Die hydrophoben Eigenschaften können jedoch durch Regen unterschiedlicher Dauer, Entladungen und die Regenerationseigenschaften des Silikons beeinflusst werden.

Eine Überwachungseinrichtung zum Überwachen des Leckstromes an einem Ableiter ist aus der US 2012/0239321 Al bekannt. Die bekannte Einrichtung ist zum Überwachen eines Wiedereinstiegs des Leckstromes nach einem Auslöseereignis des Ableiters eingerichtet.

Methoden zum Überwachen eines Leckstromes sind des Weiteren aus der JP 2000 091058 A, der CN 108 761 293 A, der US 2018/0017610 Al und der US 2014/0176336 Al bekannt.

Die Aufgabe der Erfindung ist es, ein artgemäßes Verfahren vorzuschlagen, das eine möglichst effiziente Instandhaltung der elektrischen Komponente und deren möglichst zuverlässigen Betrieb ermöglicht.

Die Aufgabe wird durch die Merkmale der unabhängigen Ansprüche 1 und 7 gelöst. Bevorzugte Weiterbildungen sind Gegenstand der abhängigen Ansprüche.

Die Aufgabe wird dadurch gelöst, dass ein am äußeren Isolator sukzessiv gemessener Kriechstrom, also ein zeitlicher Verlauf des Kriechstromes in einer Abfolge einzelner Messwerte, in Form von Messdaten gespeichert wird. Der gemessene Kriechstrom kann in Bezug auf Langzeitentwicklungen und kurzzeitige Ereignisse ausgewertet werden. Demnach wird überprüft, ob die Messdaten oder davon abgeleitete Größen einer vorbestimmten Bedingung genügen, wobei, falls die Messdaten oder die abgeleiteten Größen der vorbestimmten Bedingung genügen, eine Wartungsanweisung ausgelöst wird. Die Messung des Kriechstromes kann mittels verschiedener Messtechnologien erfolgen. Entsprechende Sensoren können auf dem äußeren Isolator angeordnet sein und die Messdaten kabelgebunden oder kabellos an einen geeigneten Empfänger übertragen werden. Im Rahmen der Erfindung kann der Kriechstrom durch direkte Messdaten oder auch beispielsweise durch zeitlich oder örtlich gemittelte Messdaten gegeben sein. Bei örtlicher Mittelung können beispielsweise Beobachtungen des Kriechstroms an verschiedenen Isolatoren bzw. Komponenten in einer Hochspanungsanlage erfolgen, wodurch ein Bild über die allgemeine Verschmutzung der Anlage ermöglicht wird, der dabei helfen kann, Ausreißer zu identifizieren und/oder Fehlinterpretationen der Messwerte zu vermeiden. Eine solche Mittelung hat den Vorteil der geringeren zu übertragenden Datenmenge. Es ist entsprechend auch denkbar, den zu übertragenden Kriechstrom, jedenfalls vor dessen Speicherung, für die Messdaten zweckmäßig auf andere Weise auszuwählen, um die Datenmenge zu verringern. Geeigneterweise werden die Messdaten sukzessive in einer zeitlichen Anordnung in einem Speichermedium einer Datenverarbeitungsanlage (oder verteilt auf mehrere Datenverarbeitungsanlagen) gespeichert. Die Rückführung von vielen Messdaten auf wenige aussagekräftige Kenndaten ist im Allgemeinen abhängig von der Abtastfrequenz des zur Verfügung stehenden Messgerätes. Bei höheren Abtastraten kann der Kriechstrom hochfrequent abgetastet und mittels eines geeigneten Algorithmus im Messgerät oder in dern Datenverarbeitungszentrale beispielsweise auf die folgenden Daten reduziert werden: Anzahl der Schwellenüberschreitungen (z.B. 1, 5, 10, 20 mA) in einem kurzen Zeitintervall (z.B. 5 Min); höchster Spitzenwert über ein kurzes Zeitintervall (z.B. 5 Min); Mittelwert über ein kurzes Zeitintervall (z.B. 5 Min). Sobald die Zähl- und Messwerte mehrere Datensätze keine Änderung bzw. unterhalb einer interessanten Schwelle fallen, können die Anzahl der gespeicherten Datensätze weiter reduziert werden. Geeigneterweise werden die gegebenenfalls bereits reduzierten Messdaten sukzessive in einer zeitlichen Anordnung in einem Speichermedium einer Datenverarbeitungsanlage (oder verteilt auf mehrere Datenverarbeitungsanlagen) gespeichert. Bei niedriger Abtastrate wird der gemessene Kriechstrom geeigneterweise auf analogem Wege geglättet (z.B. durch eine RC-Verschaltung) und es wird lediglich ein Mittelwert gemessen und übertragen.

Die Wartungsanweisung kann auf jede geeignete Weise erfolgen, beispielsweise akustisch oder visuell. Sie umfasst bevorzugt das Ergebnis der Auswertung. Die Wartungsanweisung kann beispielsweise vorsehen, die Komponente unter besondere Beobachtung zu stellen, den Isolator zu reinigen oder die Komponente auszutauschen. Die Wartungsanweisung kann mittels einer geeigneten Anzeigevorrichtung erfolgen, die beispielsweise in die Datenverarbeitungsanlage integriert ist. Es ist darüber hinaus denkbar, dass die Wartungsanweisung an ein mobiles Gerät gesendet wird, das sich beispielsweise im Besitz eines zur Wartung der Komponente Berechtigten befindet und zur Anzeige der Wartungsanweisung geeignet ist.

Die Überprüfung, ob die Messdaten die vorbestimmte Bedingung erfüllen kann mittels eines festgelegten Algorithmus erfolgen. Die Messdaten können dazu eine Zeitreihe bilden, die digital analysierbar ist. Die vorbestimmte Bedingung kann sich auf einzelne Datenpunkte der Messdaten(-Reihe) oder auf eine Teilmenge der Messdaten beziehen. Im Einzelnen kann also zum Beispiel vorbestimmt sein, dass die Bedingung erfüllt ist, wenn bereits ein einzelner Datenpunkt oder eine bestimmte Anzahl an Schwellenüberschreitungen der Messdaten die Bedingung erfüllt (wenn beispielsweise der Datenpunkt größer als ein Schwellwert ist) oder ein Anstieg der Datenwerte (bestimmt über mehrere Datenpunkte der Messdaten) einen Anstiegsschwellwert überschreitet. Die Bedingung kann jedenfalls als ein mehrstufiger Bedingungsbaum mit voneinander abhängigen Abfragen definiert sein.

Ein wesentlicher Vorteil der Erfindung besteht darin, dass das erfindungsgemäße Verfahren eine kontinuierliche und präzise Aussage über den Isolatorzustand ermöglicht. Auf diese Weise wird insgesamt die Zuverlässigkeit der elektrischen Komponente erhöht. Zugleich ermöglicht es, auf einfache und effiziente Weise eine Instandhaltung und Wartung der elektrischen Komponente. Eine Bewertung des Isolatorzustandes durch eine Person vor Ort entfällt damit vorteilhaft weitgehend bzw. eine bedarfsgerechte Wartung/Reinigung der Isolatoren kann durchgeführt werden. Weiterhin herrschen die ungünstigsten Bedingungen nur selten vor und die Wahrscheinlichkeit, dass Personal während genau dieser kritische Wetterereignisse (=ungünstigste Bedingungen) eine Inspektion durchführt, ist gering: So ist der Kriech-strom erfahrungsgemäß am stärksten beispielsweise nach einer längeren Trockenperiode ohne Regen im Sommer und am frühen Morgen während das elektrische Gerät Betauung aufweist. Eine kontinuierliche Kriechstrommessung und -überwachung auch unter Betrieb und unter allen vorkommenden Umgebungsbedingungen ist vorteilhaft unabhängig vom Isolatormaterial(HTM/Non-HTM (Hydrophobicity Transfer Material)).

Gemäß der Erfindung umfasst das Überprüfen der Messdaten auf die vorbestimmte Bedingung ein Überprüfen, ob die Messwerte eine vorbestimmte Messdatenschwelle (die nachfolgend auch als Messwertschwelle bezeichnet wird) erreichen oder überschreiten. Die Bedingung ist im einfachsten Fall durch die Definition der Messdatenschwelle festgelegt. Geeigneterweise wird demnach überprüft, ob ein einzelner Datenpunkt bzw. Datenwert der Messdaten die Messdatenschwelle erreicht oder überschreitet. Alternativ kann die Bedingung darauf gerichtet sein, ob eine Abfolge der Messdatenwerte (eine zeitlich eingegrenzte Teilmenge der Messdaten) die Messdatenschwelle erreicht oder überschreitet. Das Überschreiten der jeweiligen Messdatenschwelle wird mit-gezählt. Eine Gewichtung der Zähl- und Messwerte kann durch Bewertung der Teilbedingungen angepasst werden: Spannungsform (AC / DC); Isolatordesign (z.B. Durchmesser, Schirmform); Umgebungsbedingungen (z.B. Großwetterlage, Betauung, Meeresnähe); spezifische Spannungsbelastung (Spannung pro Baulänge). In diesem Fall wird vermieden, dass einzelne sogenannte Ausreißer fälschlicherweise die Wartungsanweisung auslösen können. Die Überprüfung auf das Erreichen bzw. Überschreiten der Messdatenschwelle kann eine Teilbedingung von mehreren Teilbedingungen der vorbestimmten Bedingung darstellen.

Erfindungsgemäß ist die Messwertschwelle eine Stromschwelle. In diesem Fall ist die Messwertschwelle direkt durch einen Stromwert gegeben. Auf diese Weise kann eine aufwendige Bearbeitung der Messdaten zur Durchführung der Überprüfung reduziert oder gar vermieden werden. Die Stromschwelle liegt zwischen 1 mA und 20 mA (Spitzenwert). Häufige Kriechstromspitzen >1 mA und seltene Kriechstromspitzen >10 mA und ein 5 Minuten Mittelwert von >1 mA können hierbei ein Indikator für die Notwendigkeit einer Wartung sein. Eigene Untersuchungen haben ergeben, dass ein Kriechstrom über den äußeren Isolator, der im genannten Bereich liegt, ein Indikator für eine Notwendigkeit einer Wartung sein kann. Insbesondere treten in einem Normalfall, in dem keine Wartung notwendig ist, Kriechströme unterhalb von 1 mA vorhanden. Liegen die gemessenen Kriechströme demnach unterhalb von 1 mA, so ist es denkbar, dass (vorerst) keine weitere Maßnahme notwendig ist.

Bevorzugt ist das Verfahren mehrstufig, wobei die Messdaten oder die abgeleitete Größe auf eine zusätzliche vorbestimmte Bedingung überprüft werden. Beispielsweise können mehrere (Teil-)Bedingungen definiert werden, die kumulativ erfüllt sein müssen. Auf diese Weise kann die Zuverlässigkeit des Verfahrens weiter erhöht werden.

Vorzugsweise umfasst die zusätzliche Bedingung das Erreichen oder Überschreiten einer weiteren Messdatenschwelle. Die weitere Messdatenschwelle erlaubt die Berücksichtigung weiterer relevanter Faktoren, die in die weitere Messdatenschwelle einfließen können.

Denkbar ist ferner eine Verknüpfung von Zählung von Schwellwertereignissen mit höchstem Spitzenwert und Mittelwert und den Teilbedingungen (den zusätzlichen Bedingungen) mittels gewichteter Faktoren.

Erfindungsgemäß wird beim Überprüfen auf die vorbestimmte Bedingung die Höhe einer Betriebsspannung der elektrischen Komponente berücksichtigt. Die Betriebsspannung ist ein Maß für die Beanspruchung der elektrischen Komponente und damit ein Faktor bei der Instandhaltung. Die Art der Betriebsspannung (AC oder DC) nimmt einen essentiellen Einfluss. Bei DC Belastung ist eine stärkere Verschmutzungsansammlung möglich durch das statische Feld. Weiterhin sind Entladungen bei DC Spannung in der Regel zeitlich länger andauernd, da der Nulldurchgang für das Verlöschen der Entladungen fehlt. Art (AC oder DC) und Höhe der Spannung wird in Form eines Faktors berücksichtigt, mit dem die Messdaten verknüpft werden (zum Beispiel durch Multiplikation), bevor ein Vergleich mit einer der Messdatenschwellen erfolgt.

Zweckmäßigerweise wird beim Überprüfen auf die vorbestimmte Bedingung ein Isolatordesign berücksichtigt. Das Isolatordesign ist im Rahmen der Erfindung bestimmend für einen Formfaktor des Isolatorprofils, beispielsweise das Profil der Isolatorschirme. Mit der Berücksichtigung des Isolatordesigns werden insbesondere eine oder mehrere der folgenden Größen berücksichtigt: eine Kriechweglänge der Isolatoroberfläche (auch Fadenmaß genannt), eine Schirmausladung von Isolatorschirmen, eine Schirmneigung von Isolatorschirmen, ein Schirmabstand zwischen einzelnen Isolatorschirmen, ein Durchmesser des Isolators. Die Berücksichtigung dieser Größen erlaubt vorteilhaft die Genauigkeit der Analyse der Messdaten zu erhöhen. Die Berücksichtigung des Isolatordesigns kann durch einen entsprechenden zusätzlichen, beispielsweise multiplikativen, Faktor erfolgen, der mit den Messdaten verknüpft wird.

Bevorzugt wird beim Überprüfen auf die vorbestimmte Bedingung wenigstens eine Umgebungsbedingung am Isolator berücksichtigt. Die Umgebungsbedingung oder auch mehrere Umgebungsbedingungen haben erfahrungsgemäß Einfluss auf den Betrieb und die Belastung der elektrischen Komponente, so dass deren Berücksichtigung die Zuverlässigkeit des Verfahrens erhöht. Die Umgebungsbedingung kann ein Regenfall, eine Länge einer Trockenphase, Wind, Betauung, Nebel und/oder Temperatur sein. Die Berücksichtigung der Umgebungsbedingung kann ebenfalls durch einen entsprechenden weiteren, beispielsweise multiplikativen, Faktor erfolgen, der mit den Messdaten verknüpft wird. Gegebenenfalls könnte die Dringlichkeit, mit der eine Reinigung empfohlen wird, herabgesetzt werden, wenn nach längerer Trockenperiode und erstmaligem Einsetzen von Regen ein gewisser Reinigungseffekt zu erwarten ist.

Geeigneterweise wird überprüft, ob die Messdaten oder die davon abgeleitete Größe einer Mehrzahl von vorbestimmten Bedingungen genügen, wobei jeder Bedingung eine separate Wartungsanweisung zugeordnet wird, die bei Vorliegen der zugeordneten Bedingung ausgelöst wird. Demnach werden mehrere Bedingungen definiert, wobei jede der Bedingungen einer eignen Wartungsanweisung zugeordnet ist. Das Erfüllen einer ersten Bedingung kann beispielsweise an die Wartungsanweisung geknüpft sein, die Komponente unter besondere Beobachtung zu stellen, eine zweite Bedingung kann an die Wartungsanweisung geknüpft sein, die Komponente bzw. den äußeren Isolator zu reinigen, eine dritte Bedingung kann an die Wartungsanweisung geknüpft sein, die Betriebsspannung abzusenken bzw. die Komponente auszutauschen, mit Silikon zu beschichten (z.B. RTV-Silikon) usw..

Die Erfindung betrifft ferner eine Datenverarbeitungsanlage.

Die Aufgabe der Erfindung ist es, eine Datenverarbeitungsanlage vorzuschlagen, mittels der eine effiziente Instandhaltung einer elektrischen Komponente ermöglicht ist.

Die Aufgabe wird erfindungsgemäß durch eine Datenverarbeitungsanlage gelöst, die zum Durchführen eines erfindungsgemäßen Verfahrens eingerichtet ist.

Die Vorteile der erfindungsgemäßen Datenverarbeitungsanlage ergeben sich insbesondere aus den Vorteilen, die bereits im Zusammenhang mit dem erfindungsgemäßen Verfahren beschrieben wurden.

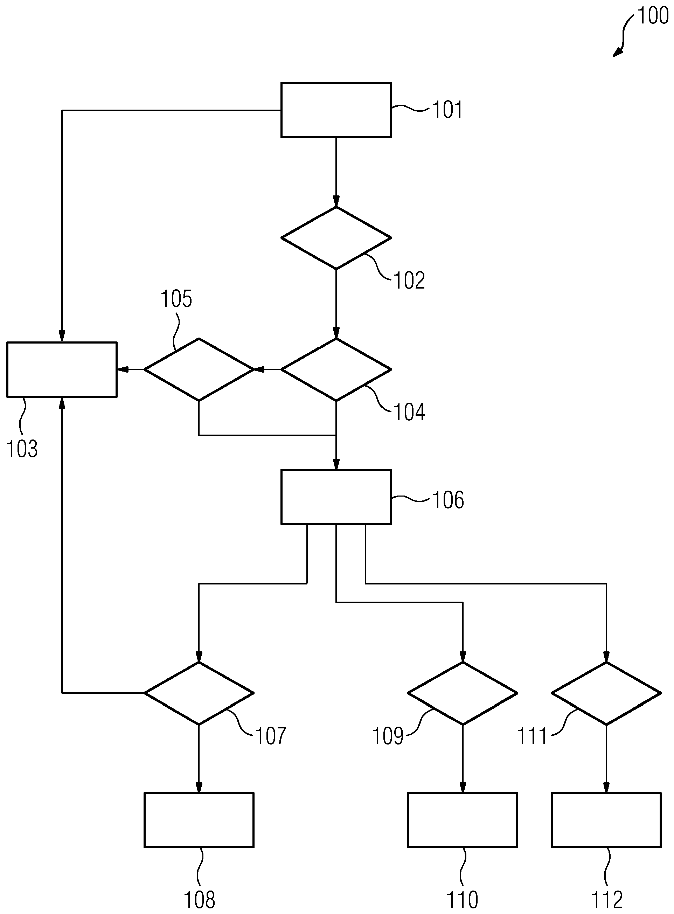

Die Erfindung wird im Folgenden anhand eines in der Figur dargestellten Ausführungsbeispiels weiter erläutert.

Die Figur zeigt ein Ausführungsbeispiel eines erfindungsgemäßen Verfahrens in einem schematischen Ablaufdiagramm. Das nachfolgend beschriebene Verfahren kann zu gewissen Teilen im Messgerät selbst durchgeführt werden. Dadurch reduziert sich die zu übertragende Datenmenge.

In einem ersten Verfahrensschritt 101 des Verfahrens 100 der Figur wird ein gemessener Kriechstrom in Form einer Abfolge von Tupeln aus einer Zeitangabe und einem Stromwert in einem Speicher des Messgerätes einer Datenverarbeitungsanlage (bsp. einem Server) gespeichert. Der Kriechstrom wird dabei als über einen äußeren Isolator einer elektrischen Komponente fließender Leckstrom gemessen und per Funk an eine Empfangskomponente der Datenverarbeitungsanlage gesendet.

In einem zweiten Verfahrensschritt 102 wird überprüft, ob die Messdaten bzw. ein aktueller Datenwert oberhalb einer ersten Messdatenschwelle von 1 mA (Spitzenwert) liegen. Ist das nicht der Fall, so wird in einem dritten Verfahrensschritt 103 eine Information ausgegeben, dass derzeit keine weitere Maßnahme notwendig ist.

Ergibt die Überprüfung in Schritt 102, dass die erste Messdatenschwelle überschritten ist, so wird in einem vierten Verfahrensschritt 104 überprüft, ob die erste Messwertschwelle auch nach einem kritischen Wetterereignis (wie z.B. einer einen Monat andauernden Trockenheitsperiode) überschritten ist.

Ist dies der Fall, so wird in einem fünften Verfahrensschritt 105 überprüft, ob die Messdaten eine zweite Messdatenschwelle von 5 mA (Spitzenwert) unterschreiten. Falls ja, wird Verfahrensschritt 103 ausgeführt. Falls die Überprüfung im Verfahrensschritt 104 oder im Verfahrensschritt 105 ein negatives Ergebnis liefert, wird in einem sechsten Verfahrensschritt 106 eine Bewertung des Isolationsdesigns und der Höhe der Betriebsspannung durchgeführt. In Abhängigkeit von der Bewertung wird ein Faktor festgelegt, der einen Wert von eins oder größer haben kann. Die Messdaten werden anschließend mit diesem dimensionslosen Faktor multipliziert, wobei sich ein Vergleichswert ergibt. Dabei wird ein desto höherer Faktor festgelegt, je ungünstigere Eigenschaften bezüglich des Isolatordesigns und der Beanspruchung die betrachtete elektrische Komponente aufweist. Es wird hierbei insbesondere, falls die Überprüfung im Verfahrensschritt 104 oder im Verfahrensschritt 105 ein negatives Ergebnis liefert, wird in einem sechsten Verfahrensschritt 106 eine Gewichtung der Messdaten durchgeführt. Hierbei werden die Anzahl der Schwellwertüberschreitungen (1, 5, 10, 20 mA), höchste Spitzenwert und der Mittelwert im Messintervall gewichtet und in einem übergeordnetem Gefährdungsfaktor zusammengeführt und grafisch dargestellt (Trendlinie/Histogramm). Die Wichtung ist auch durchführbar, wenn nur Teile der genannten Messdaten zur Verfügung stehen. Auch die anderen genannten Teilbedingungen (Art der Spannung, Isolatordesign, etc.) fließen als Multiplikator in den Gefährdungsfaktor mit ein.

Der Gefährdungsfaktor, ausgedrückt in Prozent, bezeichnet die Gefährdung des Isolators durch Verschmutzung und Kriechstrom. Hierbei bezeichnet der Wert 100 % einen Zustand, indem sich der Isolator kurz vor dem Überschlag befindet
Anschließend wird in einem siebten Verfahrensschritt 107 überprüft, ob der Vergleichswert (Gefährdungswert) unterhalb von 30% liegt. Falls ja, wird der dritte Verfahrensschritt 103 durchgeführt. Falls nein, und der Vergleichswert (Gefährdungswert) 70% nicht überschreitet, dann wird in einem achten Verfahrensschritt 108 eine Wartungsanweisung ausgegeben, wonach der Isolator unter besondere Beobachtung gestellt werden soll. Zugleich wird eine weitere Auswertung durchgeführt, wie oft und für wie lange der Vergleichswert über 30% bleibt.

In einem neunten Verfahrensschritt 109 wird überprüft, ob der Vergleichswert oberhalb von 70% liegt. Falls ja, und falls der Vergleichswert 90% nicht überschreitet, wird in einem zehnten Verfahrensschritt 110 eine Wartungsanweisung ausgegeben, wonach eine Reinigung des Isolators zügig durchgeführt werden soll.

In einem elften Verfahrensschritt 111 wird überprüft, ob der Gefährdungswert oberhalb von 90 % liegt. Falls ja, wird in einem zwölften Verfahrensschritt 112 eine Wartungsanweisung ausgegeben, wonach eine zügige Reinigung notwendig ist und die Betriebsspannung unter bestimmten klimatischen Bedingungen (z.B. morgendliche Betauung, Nebel, Starkregen, etc.) an der elektrischen Komponente abgesenkt werden soll, um deren Beanspruchung zu reduzieren. Bei häufiger Wiederkehr der Bedingung 90% Gefährdung ist eine Silikonbeschichtung des Isolators oder Austausch des Isolators (mit eventueller Designänderung) zu erwägen.

Die Ausgabe der Wartungsanweisungen wird hierbei mittels einer visuellen Anzeige eines entsprechenden Textes durchgeführt. Dazu verfügt die Datenverarbeitungsanlage über ein entsprechendes Display.

## Patentansprüche

1. Verfahren zum Instandhalten einer elektrischen Komponente mit einem äußeren Isolator, bei dem
- ein am äußeren Isolator sukzessiv gemessener Kriechstrom in Form von Messdaten gespeichert wird,
- überprüft wird, ob die gespeicherten Messdaten oder davon abgeleitete Größen einer vorbestimmten Bedingung genügen,
- falls die Messdaten oder die abgeleiteten Größen der vorbestimmten Bedingung genügen, eine Wartungsanweisung ausgelöst wird, **dadurch gekennzeichnet dass**
das Überprüfen der Messdaten auf die vorbestimmte Bedingung ein Überprüfen umfasst, ob die Messwerte eine vorbestimmte Messdatenschwelle erreichen oder überschreiten, wobei die Messdatenschwelle eine Stromschwelle ist, wobei die Stromschwelle zwischen 1 mA und 20 mA liegt, wobei beim Überprüfen auf die vorbestimmte Bedingung die Art und Höhe einer Betriebsspannung der elektrischen Komponente berücksichtigt wird, wobei die Art und Höhe der Betriebsspannung in Form eines Faktors berücksichtigt werden, mit dem die Messdaten verknüpft werden, bevor ein Vergleich mit einer der Messdatenschwellen erfolgt.

2. Verfahren nach Anspruch 1, wobei das Verfahren mehrstufig ist, wobei die Messdaten oder die abgeleitete Größe auf eine zusätzliche vorbestimmte Bedingung überprüft werden.

3. Verfahren nach Anspruch 2, wobei die zusätzliche Bedingung das Überschreiten einer weiteren Messdatenschwelle umfasst.

4. Verfahren nach einem der vorangehenden Ansprüche, wobei beim Überprüfen auf die vorbestimmte Bedingung ein Isolatordesign berücksichtigt wird.

5. Verfahren nach einem der vorangehenden Ansprüche, wobei beim Überprüfen auf die vorbestimmte Bedingung eine Umgebungsbedingung am Isolator berücksichtigt wird.

6. Verfahren nach einem der vorangehenden Ansprüche, wobei überprüft wird, ob die Messdaten oder die davon abgeleitete Größe einer Mehrzahl von vorbestimmten Bedingungen genügen, wobei jeder Bedingung eine separate Wartungsanweisung zugeordnet wird, die bei Vorliegen der zugeordneten Bedingung ausgelöst wird.

7. Datenverarbeitungsanlage, die zum Durchführen eines Verfahrens nach den Ansprüchen 1 bis 6 eingerichtet ist.

## Claims

1. A method for maintaining an electrical component with an external insulator, wherein
- a leakage current successively measured at the external insulator is stored in the form of measurement data,
- it is checked whether the stored measurement data or variables derived therefrom satisfy a predetermined condition,
- if the measurement data or the derived variables satisfy the predetermined condition, a maintenance instruction is triggered, **characterised in that**
checking the measurement data for the predetermined condition comprises checking whether the measurement values reach or exceed a predetermined measurement data threshold, wherein the measurement data threshold is a current threshold, wherein the current threshold is between 1 mA and 20 mA, wherein, when checking for the predetermined condition, the type and level of an operating voltage of the electrical component are taken into account, wherein the type and level of the operating voltage are taken into account in the form of a factor with which the measurement data are linked before a comparison with one of the measurement data thresholds takes place.

2. The method according to claim 1, wherein the method is multi-stage, wherein the measurement data or the derived variable are checked for an additional predetermined condition.

3. The method according to claim 2, wherein the additional condition comprises exceeding a further measurement data threshold.

4. The method according to any one of the preceding claims, wherein an insulator design is taken into account when checking for the predetermined condition.

5. The method according to any one of the preceding claims, wherein an environmental condition on the insulator is taken into account when checking for the predetermined condition.

6. The method according to any one of the preceding claims, wherein it is checked whether the measurement data or the variable derived therefrom satisfy a plurality of predetermined conditions, wherein a separate maintenance instruction is assigned to each condition, which is triggered when the assigned condition is present.

7. A data processing system, which is configured to carry out a method according to claims 1 to 6.

## Revendications

1. Procédé d'entretien d'un composant électrique comportant un isolant extérieur, comprenant :
- un courant de fuite mesuré successivement sur l'isolant extérieur est stocké sous forme de données de mesure,
- la vérification que les données de mesure enregistrées ou les quantités qui en sont dérivées satisfont à une condition prédéfinie,
- si les données mesurées ou les quantités dérivées satisfont la condition prédéterminée, une instruction de maintenance est déclenchée, **caractérisé en ce que**
la vérification des données de mesure pour la condition prédéterminée comprend la vérification si les valeurs mesurées atteignent ou dépassent un seuil de données de mesure prédéterminé, le seuil de données de mesure étant un seuil de courant, le seuil de courant étant compris entre 1 mA et 20 mA, le type et le niveau d'une tension de fonctionnement du composant électrique étant pris en compte lors de la vérification de la condition prédéterminée, le type et le niveau de la tension de fonctionnement étant pris en compte sous la forme d'un facteur auquel les données de mesure sont liées,
avant qu'une comparaison avec l'un des seuils de données de mesure ne soit effectuée.

2. Procédé selon la revendication 1, dans lequel le procédé est à plusieurs étapes, dans lequel les données de mesure ou la quantité dérivée sont vérifiées pour une condition prédéterminée supplémentaire.

3. Procédé selon la revendication 2, dans lequel la condition supplémentaire comprend le dépassement d'un autre seuil de données de mesure.

4. Procédé selon l'une des revendications précédentes, dans lequel une conception d'isolateur est prise en compte lors de la vérification de la condition prédéterminée .

5. Procédé selon l'une quelconque des revendications précédentes, dans lequel une condition ambiante au niveau de l'isolateur est prise en compte lors de la vérification de la condition prédéterminée.

6. Procédé selon l'une quelconque des revendications précédentes, dans lequel une vérification est effectuée pour déterminer si les données de mesure ou la grandeur qui en est dérivée satisfont à une pluralité de conditions prédéterminées, chaque condition étant associée à une instruction de maintenance distincte qui est déclenchée lorsque la condition associée est remplie.

7. Système de traitement de données qui est configuré pour mettre en œuvre un procédé selon les revendications 1 à 6.
